# EUROPEAN PATENT APPLICATION

(11) **EP 0 596 472 A2**
(43) Date of publication of application: **11.05.1994**
(21) Application number: 93117820.6
(22) Date of filing: 03.11.1993
(51) Int. Cl.: H02H 7/08

(54) **Circuit arrangement for feeding an inductive load**

(30) Priority: 03.11.1992 DE 4237127
(71) Applicant: TEXAS INSTRUMENTS DEUTSCHLAND GMBH, D-85356 Freising (DE)
(72) Inventor: Scoones, Kevin, D 85368 Moosburg (DE)
(74) Representative: Schwepfinger, Karl-Heinz, Dipl.-Ing.

(57) **Abstract**

A circuit arrangement for feeding an inductive load (M) comprises, for gate control via a control circuit(12), a plurality of power transistors (T,-T₄) forming an H-bridge (14), to the output terminals (A, B) of which the inductive load (M) is connected. The control circuit is compatible with an overvoltage detector means (16, 18) assigned to the output (A, B) of the H-bridge (14) to control the power transistors (T₁-T₄) in the sense of an overvoltage suppression should an overvoltage situation occur.

## Description

The invention relates to a circuit arrangement for feeding an inductive load comprising, for gate control via a control circuit, a plurality of power transistors forming an H-bridge, to the output terminals of which the inductive load is connected.

H-bridges comprising. for example, four power transistors which are switched on in pairs according to the desired direction of current serve to power feed, among other things, electric motors. Since any electric motor represents an inductive load, considerable induced voltages may arise when the load is switched off, the value of which may amount to a multiple of the operating voltage. Such voltage spikes may easily result in the power transistors being ruined. It is, therefore, usually the case to design the circuitry so that the power transistors are protected from such overvoltages.

For this purpose it has already been proposed to provide the output of H-bridges with a circuit arrangement comprising Zener diodes to clamp the output voltage to a value in the range of the supply voltage. This circuit proposal has , however, the disadvantage that the voltage clamp can only always correspond to an integer multiple of a Zener diode voltage. In addition, the voltage clamp must always be dimensioned large enough to be able to absorb the resulting energy.

The object of the invention is to provide a circuit arrangement of the aforementioned kind to ensure optimum overvoltage protection with a minimum of additional circuitry.

This object is achieved according to the invention by the control circuit being driven by an overvoltage detector means assigned to the output of the H-bridge for gate control of the power transistors in the sense of an overvoltage suppression should an overvoltage situation occur.

Due to this configuration the existing power transistors being naturally generously dimensioned are simultaneously used also as the voltage clamp. The additional circuitry required and particularly also the additional requirement as to the silicon surface area are reduced to a minimum in the case of an integrated solution. Selecting the clamp voltage is subject to no restraints whatsoever.

In an overvoltage situation preferably only one power transistor is conducting in each case whilst any other power transistor is bypassed by a diode. As a result, any induced current occurring is able to leave the circuit via the ON power transistor and the diode.

The overvoltage detector means can be configured relatively simple and comprise in particular a comparator with a transistor, the emitter and base of which form the two comparator inputs and the collector-base circuit of which lies in the input circuit of a current mirror.

The subclaims cite further advantagous embodiments of the circuit arrangement according to the invention.

The invention will now be described in more detail on the basis of an example embodiment of the circuit arrangement according to the invention with reference to the drawing in which:
Fig. 1 is a schematic representation of a circuit arrangement for feeding a motor, and
Fig. 2 shows the the switching principle of a comparator of the overvoltage detector means.

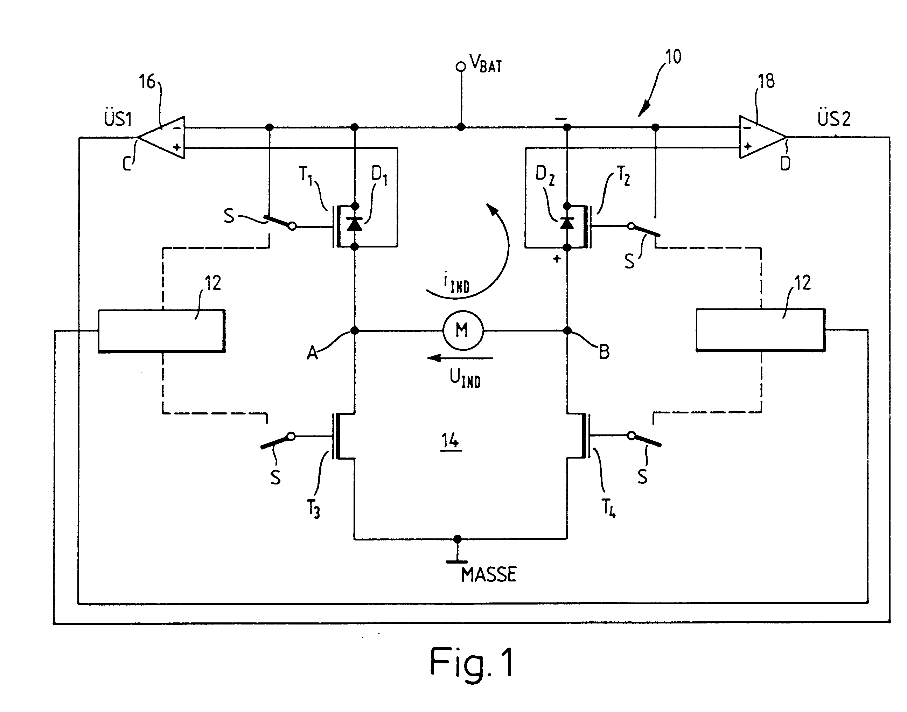

The circuit arrangement 10 shown in Fig. 1 serves to feed an electric motor M representing an inductive load circuited between the two output terminals A,B of an H-bridge controlled by a control circuit 12.

The H-bridge 14 comprises four power MOS field-effect transistors T₁-T₄ whereby the power transistors T₁ and T₂ are employed as high-side drivers (HSD) and the power transistors T₃, T₄ as low-side drivers (LSD).

The drain terminals of the two power transistors T₁, T₂ are connected to the supply voltage terminal exhibiting the positive potential V_{Bat} whilst the source terminals of the power transistors T₃, T₄ are connected to ground (GND). The source terminals of the power transistors T₁ and T₂ are connected to the drain terminals of the power transistors T₃ and T₄ respectively. The output terminal A of the H-bridge 14 is located at a node between the source terminal of the power transistor T₁ and the drain terminal of the power transistor T₃, whilst the output terminal B of the H-bridge 14 is located at a node between the source terminal of the power transistor T₂ and the drain terminal of the power transistor T 4.

The gate terminals of the four power transistors T₁-T₄ of the H-bridge 14 can be controlled via the control circuit 12 as indicated by the switch S and the control lines indicated dashed between the latter and the control circuit 12.

To feed the electric motor M the power transistors T1-T4 are each paired ON according to the desired current direction and thus for one current direction the two power transistors T₁ and T₄ are ON and for the other current direction the two power transistors T₂ and T₃ are ON whilst the remaining transistors are each OFF.

In the example embodiment shown schematically in Fig. 1 the gate terminals of the power transistors T₁, T₂ are each placed at the same potential V_{bat} as the corresponding drain terminals to turn these transistors ON. However, it is also possible, of course, to switch the gate terminals, for example, to a potential higher than that of the drain terminals.

The control circuit 12 ensuring normal operation is additionally controlled by an overvoltage detection means 16, 18 comprising two comparators 16 and 18 respectively which are assigned differing output terminals A, B of the H-bridge 14 to ensure corresponding monitoring of the potentials resulting at the source terminals of the power transistors Ti and T₂.

In this arrangement the output terminal A of the H-bridge 14 and source terminal of the power transistor T₁ respectively is connected to the positive input of the comparator 16, the negative input of which is connected to the positive supply voltage terminal V_{Bat}.

The output terminal B of the H-bridge 14 and the source terminal of the power transistor T₂ respectively is connected to the positive input of the comparator 18, the negative input of which is in turn connected to the positive supply voltage terminal V_{B}at.

The comparator 16 furnishes at its output C an overvoltage signal S1 as soon as an overvoltage exceeding the supply voltage occurs at the output terminal B or at the source terminal of the power transistor T₂.

The outputs C,D of the two comparators 16, 18 are each connected to the control circuit 12 receiving the corresponding overvoltage signal S1 and S2 respectively to control at least part of the power transistors T₁-T₄ in the sense of an overvoltage suppression, should an overvoltage condition occur.

In the example embodiment illustrated in Fig. 1 only one power transistor is ON in an overvoltage condition, any other power transistor being bypassed by a diode for the induced current i_{ind}. In the case in question, for a corresponding overvoltage suppression either the power transistor T₁ or the power transistor T₂ is ON whilst the other power transistor T₂ and T₁ respectively is bypassed by a diode D₂ and D₁ respectively for the induced current i_{ind}. The two remaining power transistors T₃, T₄ remain OFF when an overvoltage has been detected and are thus not included in control of overvoltage suppression. It is, of course, feasible, however, to also make use of the two power transistors T₃, T₄ to suppress overvoltages or induced voltages caused by a power OFF.

The diodes D1 and D2 assigned respectively to the two power transistors T₁ and T₂ are reverse circuited between the drain terminals and source terminals, they only being conducting in an overvoltage condition when the potential at the output terminal A and output terminal B respectively is higher than the potential V_{Bat} of the supply voltage.

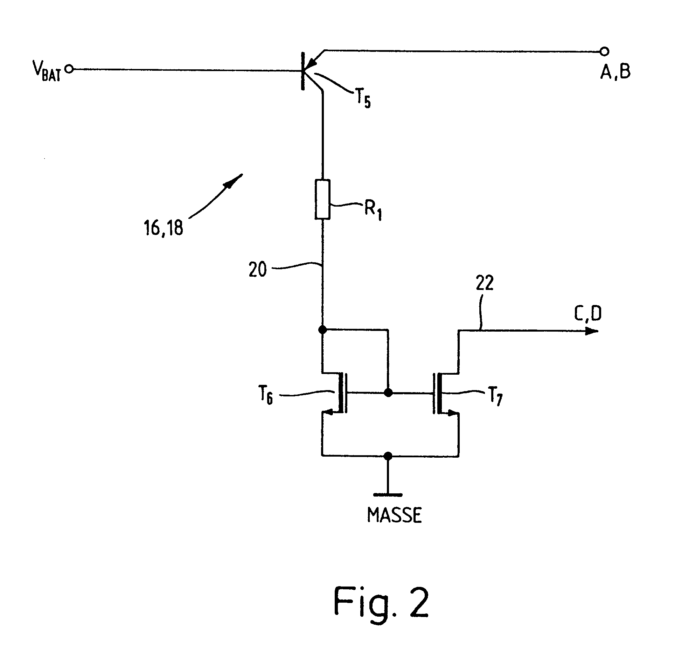

Fig. 2 shows a simple embodiment of a comparator 16 and 18 respectively of the overvoltage detector means.

This comparator 16 and 18 respectively comprises a pnp transistor T5, the emitter of which is connected to the positive inputs of the comparator and correspondingly to the relative output terminal A, B of the H-bridge 14, whilst its base forms the negative input of the comparator and correspondingly receives the positive potential V_{Bat} of the voltage supply.

The collector of transistor T₅ is connected to a resistor R₁ forming together with a series transistor diode T₆ the input circuit 20 of a current mirror 20, 22, this transistor diode being formed by a field-effect transistor T₆ having a short-circuited drain- gate circuit, the drain terminal of which is connected to the resistor R₁ whilst its source terminal is connected to ground (GND). The output circuit 22 of the current mirror 20, 22 comprises a further field-effect transistor T₇, the source terminal of which is connected to ground whilst its drain terminal forms the output C, D of the comparator 16 and 18 respectively (viz. Fig. 1). The gate terminal of this field-effect transistor T₇ is connected to that of the field-effect transistor T₆.

Since in this circuit arrangement the drain- source voltage of the transistors is the same as the gate-source voltage, self-reversing field-effect transistors are to be used to achieve the current mirror.

The function of the circuit arrangement according to the invention is as follows:
During normal operation the electric motor M is powered either via the power transistors T₁ and T₄ or via the power transistors T₂ and T₃.

If the electric motor M is turned OFF subsequently to power being provided via the power transistors T₁ and T₄ an induced voltage U_{Ind} results between the output terminals B, A of the H-bridge 14 producing at the output terminal B a potential which is higher than the positive potential Vast of the supply voltage.

This overvoltage resulting at the output terminal B of the H-bridge 14 and source terminal of power transistor T₂ respectively is detected by the comparator 18 which then furnishes its output D with a corresponding overcurrent signal S2 which is received by the control circuit 12. Due to this overcurrent signal S₂ received by the comparator 18 power transistor T₁ is ON via the control circuit 12 so that the induced current _{hnd} resulting on power OFF of the electric motor M can be discharged via this power transistor T₁ and the diode D₂ assigned to power transistor T₂ which is now switched off. Like the power transistor T₂ power transistors T₃ and T₄ also remain OFF. As soon as the induced voltage U_{Ind} has been depleted, the remaining power transistor T₁ is also switched off.

When, on the other hand, the electric motor M is turned OFF following power supply via the power transistor T₂ and the power transistor T₃, a potential higher than that of V_{Bat} occurs at the output terminal A of the H-bridge which is detected by the other comparator 16 which then supplies a corresponding overvoltage signal S1 to the control circuit 12.

As a result of this overvoltage signal S1 stemming from the comparator 16 power transistor T₂ is now ON so that the resulting induced current i_{ind} can be discharged via this power transistor T₂ and the diode D₁ assigned to the power transistor T₁. In this case the power transistors T₁, T₃ and T₄ remain OFF after the power has been switched off. As soon as the induced voltage U_{Ind} occurring during power OFF has been depleted, power transistor T₂ is also switched off.

The control circuit 12 is thus configured so that it distinguishes between the overvoltage signals S1 and S2 stemming respectively from the two comparators 16 and 18 as is indicated in Fig. 1 by the dual representation of this control circuit 12.

## Claims

1. A circuit arrangement for feeding an inductive load (M) comprising, for gate control via a control circuit (12), a plurality of power transistors (T₁-T₄) forming an H-bridge (14), to the output terminals (A, B) of which said inductive load (M) is connected, characterized in that said control circuit (12) is driven by an overvoltage detector means (16, 18) assigned to the output (A, B) of the H-bridge (14) to control said power transistors (T₁-T₄) in the sense of an overvoltage suppression should an overvoltage situation occur.

2. A circuit arrangement according to claim 1, characterized in that said overvoltage detector means (16.18) and said control circuit (12) are configured to suppress the induced voltages (_{Ulnd}) occurring during power OFF of said inductive load (M).

3. A circuit arrangement according to claim 1 or 2, characterized in that in an overvoltage condition only one power transistor (Ti, T₂) is switched conducting in each case whilst any other power transistor (T₂, T₁) is bypassed by a diode (Dᵢ , D₂) for the induced current (i_{Ind}).

4. A circuit arrangement according to any of the above claims, characterized in that said overvoltage detector means comprise at least one comparator (16, 18) the two inputs of which are connected to an output terminal (A, B) of said H-bridge (14) and a supply voltage terminal (V_{Bat}).

5. A circuit arrangement according to claim 4, characterized in that each output terminal (A, B) of said H-bridge (14) is assigned one comparator (16, 18) each.

6. A circuit arrangement according to claim 4 or 5, characterized in that the corresponding output terminal (A, B) of said H-bridge (14) is connected to the positive input of said comparator (16, 18), the negative input of which is connected to the positive supply voltage terminal (V_{B}at).

7. A circuit arrangement according to any of the claims 4 to 6, characterized in that said comparator (16, 18) comprises a transistor (T5) the emitter and base of which forms the two comparator inputs and the collector of which is connected to a resistor (R1) which in series with a diode, particularly with a transistor diode (T6) forms the input circuit (20) of a current mirror (20, 22).

8. A circuit arrangement according to claim 7, characterized in that said transistor (Tₛ) is a pnp transistor, the emitter of which is connected to the corresponding output terminal (A, B) of said H-bridge (14) and the base of which is connected to the positive supply voltage terminal (V_{Ba}t).

9. A circuit arrangement according to any of the above claims, characterized in that said power transistors (Ti - T₄) are metal oxide semiconductor (MOS) field-effect transistors.

10. A circuit arrangement according to claim 9, characterized in that said H-bridge (14) comprises two MOS field-effect transistors (Ti, T₂) employed as high-side drivers (HSD) and two MOS field-effect transistors (T₃, T 4) employed as low-side drivers (LSD).

11. A circuit arrangement according to claim 10, characterized in that in an overvoltage condition at least one each of said MOS field-effect transistors (Tᵢ, T₂) employed as high-side drivers (HSD) can be controlled in the sense of an overvoltage suppression.

12. A circuit arrangement according to any of the above claims, characterized in that said inductive load is an electric motor (M).
